(19)

Europäisches
Patentamt
European
Patent Office
Office européen
des brevets

(11) **EP 3 553 537 A1**

(12) **EUROPEAN PATENT APPLICATION**
published in accordance with Art. 153(4) EPC

(43) Date of publication:
**16.10.2019  Bulletin 2019/42**

(51) Int Cl.:
**G01R 27/00** (2006.01)

(21) Application number: **17878159.7**

(22) Date of filing: **29.03.2017**

(86) International application number:
**PCT/CN2017/078483**

(87) International publication number:
**WO 2018/103236 (14.06.2018 Gazette 2018/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **08.12.2016  CN 201611123569**

(71) Applicant: **Hefei Institutes of Physical Sicence, Chinese**
**Academy of Sciences**
**Hefei, Anhui 230031 (CN)**

(72) Inventors:
• **HU, Yanlan**
 **Hefei**
 **Anhui 230031 (CN)**
• **FU, Peng**
 **Hefei**
 **Anhui 230031 (CN)**
• **ZHU, Chongming**
 **Nanjing**
 **Jiangsu 211100 (CN)**
• **XIAO, Yezheng**
 **Hefei**
 **Anhui 230031 (CN)**

• **PAN, Chao**
 **Hefei**
 **Anhui 230031 (CN)**
• **LU, Jianhua**
 **Hefei**
 **Anhui 230031 (CN)**
• **LV, Huanyu**
 **Hefei**
 **Anhui 230031 (CN)**
• **CHEN, Bin**
 **Hefei**
 **Anhui 230031 (CN)**
• **WANG, Teng**
 **Hefei**
 **Anhui 230031 (CN)**
• **ZHENG, Longgui**
 **Hefei**
 **Anhui 230031 (CN)**
• **NI, Qicai**
 **Hefei**
 **Anhui 230031 (CN)**

(74) Representative: **Klunker IP**
**Patentanwälte PartG mbB**
**Destouchesstraße 68**
**80796 München (DE)**

(54) **QUENCH DETECTION METHOD FOR SUPERCONDUCTING MAGNET USING RADIO FREQUENCY WAVE TECHNOLOGY**

(57)    The present invention discloses a method using radio-frequency technology for superconducting magnet quench detection, comprising an inductor to be tested, a balance, an isolated annular assembly, a power source, an equilibration treatment part and a testing closed-loop system; the present invention makes use of external instruments and technology on detection of traveling wave of microwave transmission line for diagnosis of superconducting quench so as to provide an external backup detection approach available for flexible configuration to make up deficiencies to conventional approaches or serve as emergency equipment. The equipment mainly comprise four parts, namely high-stability power source, isolated annular assembly, balanced-unbalanced conversion Balance and receiving detection closed loop. Place the inductance coil (DUT) in the Dewar; the coil will change the load impedance from 0+joo at the outlet of Dewar to 0+j0 approximately through balance conversion. Characteristic impedance of transmission line will be available for regulation through design of different balance impedance converters.

EP 3 553 537 A1

FIG 1

**Description**

**Field of the Invention**

The present invention is related to the technical field of superconducting coil quench detection, in particular to a method using radio-frequency technology for superconducting magnet quench detection.

**Background Arts**

One of important breakthroughs in study of controllable thermonuclear fusion energy is the successful application of superconducting technology to the coil that can produce Tokamak high-intensity magnetic field. Full superconducting Tokamak can realize stable operation, which can lay down an engineering and physical foundation for prospective steady and advanced fusion reactor through significant improvement of constraints under steady operation conditions. Full superconducting feature serves as the prerequisite for steady operation of commercial reactors in the future.

Traditional methods for detection of superconducting protection signals of superconducting coil mainly include voltage detection method, temperature rise detection method, pressure detection method, flow detection method, ultrasonic inspection and so on.

Temperature rise detection method aims to define the quench through real-time detection of temperature variation or temperature variation velocity to the superconducting coil. Taking superconducting energy storage system of Institute of Electrical Engineering, Chinese Academy of Sciences for instance, such detection method is approximate to the nature of physical phenomenon owing to its high detection speed and high sensitivity.

In view of numerous temperature distribution points, temperature transducer and follow-up measuring system shall have high measurement precision and stability.

Pressure and flow detection method is also an important basis for definition of quench; however, it has such disadvantages as slow response of sensor, time delay and diversified influential factor; temperature rise, pressure and flow detection method mainly serve as backup protection of quench detection as well as a comprehensive basis for quench judgment. Among numerous quench detection methods, voltage detection method is the most effective method frequently used.

Basis for judgment of quench with voltage detection method: Occurrence of quench can be confirmed if superconducting detection signal voltage exceeds the threshold voltage with duration up to the set delay time.

Bridge method and co-winding detection method are the two common methods for judgment of voltage threshold value; wherein, bridge method is mainly applied to such superconducting devices as HT-7 Tokamak (out of service) of Institute of Plasma Physics, Chinese Academy of Sciences, superconducting energy storage system (SMSE) of Institute of Electrical Engineering, Chinese Academy of Sciences and LHD device of Japan; such quenching detection method aims to obtain quench detection signal based on Wheatstone Bridge Balance Theory.

Advantages: Easy use, limited circuits as required by quench detection and sensitive quench response.

Disadvantages: On one hand, there exists blind spot to the quench detection; on the other hand, the resistance to electromagnetic interference is unsatisfactory.

Co-winding detection method is mainly applicable to EAST device of Institute of Plasma Physics, Chinese Academy of Sciences; such quench detection method makes use of co-winding superconducting coil to form a sampling circuit for quench detection through co-winding, and takes the voltage signal obtained as the benchmark voltage; meanwhile, current differential signal of electrified coil as measured by the sensor is to be taken as secondary offset voltage; proceed with accumulation of secondary offset voltage and benchmark voltage as per certain compensation factor to offset induction voltage produced by coupling between its coil and other rapid alternating coils; use the voltage as obtained following accumulation for quench measurement.

Advantages: It can realize quench detection in the environment with quick changing magnetic field owing to its high sensitivity.

Disadvantages: It will be beyond repair once co-winding wire is broken.

Superconducting quench detection is a very important technology; existing superconducting quench detection technologies as frequently used have such problems as internal faults and breakage of connecting wire, which may result in failed detection and high work load to disassembly and repair; moreover, its shutdown may result in delay in system process.

**Summary of the Invention**

The purpose of present invention is to make up existing technical defects, and provide a method using radio-frequency wave technology for quench detection of superconducting magnet.

The present invention is realized based on the following technical solutions:

A method using radio-frequency technology for superconducting magnet quench detection, characterized in that it comprises an inductor to be tested, a balance, an isolated annular assembly, a power source, an equilibration treatment part and a testing closed-loop system; the said inductor to be tested is place in the Dewar; the said equilibration treatment part comprises an auxiliary equilibration part, a radio-frequency equilibration part, a carrier wave equilibration part and a DC equilibration part; the said power source is connected to the isolated annular assembly, auxiliary equilibration part and carrier wave equilibration part respectively; impedance to the said inductor to be tested is to be converted by the Balance to change the load impedance at the outlet of Dewar from 0+joo to 0+j0; j is an imaginary number; the converted load impedance is to be sent to the radio-frequency equilibration part, subjecting to isolation by the said isolated annular assembly; meanwhile, radio-frequency equilibration part will receive inherent equilibration signal from the auxiliary equilibration part to offset unconverted part of carrier wave for simultaneous amplification of residual carrier wave and variable power; the amplified signal will pass through carrier wave equilibration part; the carrier wave equilibration part will convert signal received into DC voltage variation signal that is to be sent to the testing closed-loop system subjecting to further equilibration treatment by the DC equilibration part; the testing closed-loop system aims to realize testing of variation component and output of calculations.

The said isolated annular assembly comprises a circulator and two isolators respectively connected to the circulator; output terminal of the balance is connected to the circulator; one isolator is connected to the power source; whereas the other one is connected to the radio-frequency equilibration part.

The said power source is combined via the power combiner.

The said testing closed-loop system aims to realize testing of variation component; details are stated as follows: Mathematical expression of carrier wave signal is stated as follows:

$$U_{testing} = [A+Bf(t)]*\cos(\omega t + \Delta\varphi)$$

Wherein, A refers to amplitude of fundamental component of reflected wave; f(t) refers to impact of impedance variation on reflection power after quenching; B refers to amplitude of variable power component of reflected wave; $\Delta\phi$ refers to variation component of reflected wave phase after quenching; according to mixing theory, the expression following synchronized frequency mixing is stated as follows:

$$1/2 [A+Bf(t)]*\cos(\Delta\varphi) + 1/2 [A+Bf(t)]*\cos(2\omega t + \Delta\varphi),$$

Filter circuit is used to filter $2\omega t$ high-frequency component; residual components following synchronized frequency mixing by the system mainly comprise DC component and variation component converted by the power level as well as phase variation component; viewing from simulation analysis, it can be seen that phase variation component is basically below 0.1; therefore, $\cos(\Delta\varphi)$ is approximately equal to 1; system variation component is divided into DC component and slow variation component; in other words, final closed-loop voltage value $U_{testing}$ is = A+Bf(t).

There will be no variation power component BF(t) =0 if there is no quenching; in view of variation to $U_{testing}$ as incurred by variation to load impedance in case of quenching, real-time monitoring closed-loop can obtain DC voltage output signals at superconducting state for comparison with DC voltage value of fundamental component; meanwhile, to overcome impact from noise produced by system testing, quenching is to be confirmed when the voltage difference is out of certain range.

The present invention aims to make use of radio-frequency wave technology to detect variation to internal resistance of inductance coil at superconducting status to realize quench detection. It is expected to amplify and detect potential power variation (variation to reflection coefficient as incurred by variation to DUT internal resistance) through receiving of reflection power of isolated annular assembly and precise measurement of slight power variation incurred by variation to reflection coefficient to realize quench detection.

Place the inductance coil (DUT) in the Dewar; the coil will change the load impedance from 0+joo at the outlet of Dewar to 0+j0 approximately through balance conversion. Characteristic impedance of transmission line will be available for regulation through design of different balance impedance converters.

Auxiliary equilibration mainly aims to realize such functions as sampling and judgment of main signals, generation, amplification and phase control of equilibration signals as well as closed loop of inherent stability.

According to its major principles, equilibration aims to make use of inherent equilibration signals to offset unchanged part of carrier wave, and simultaneously amplify residual carrier wave and variable power with the help of amplifier so as to reduce system's dynamic demands, and obtain sampling signals of higher precision.

The present invention has the following advantages: The present invention makes use of external instruments and technology on detection of traveling wave of microwave transmission line for diagnosis of superconducting quench so as to provide an external backup detection approach available for flexible configuration to make up deficiencies to conventional approaches or serve as emergency equipment.

**Description of Drawings**

FIG 1 is the block diagram showing working principles of the present invention.
FIG 2 is the block diagram of power source
FIG 3 is the block diagram of isolated annular assembly.
FIG 4 is the working diagram for radio-frequency equilibration part

**Preferred Embodiments**

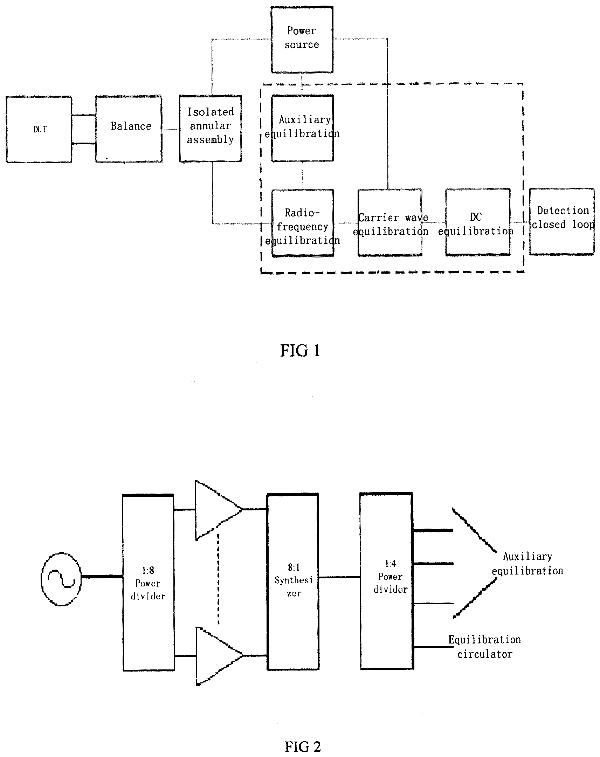

A method using radio-frequency technology for superconducting magnet quench detection as shown in FIG 1 comprises an inductor 1 to be tested, a balance 2, an isolated annular assembly 3, a power source 4, an equilibration treatment part 5 and a testing closed-loop system 6; the said inductor 1 to be tested is place in the Dewar; the said equilibration treatment part 5 comprises an auxiliary equilibration part 7, a radio-frequency equilibration part 8, a carrier wave equilibration part 9 and a DC equilibration part 10; the said power source 4 is connected to the isolated annular assembly 3, auxiliary equilibration part 7 and carrier wave equilibration part 9 respectively; impedance to the said inductor to be tested is to be converted by the Balance to change the load impedance at the outlet of Dewar from 0+joo to 0+j0; j is an imaginary number; the converted load impedance is to be sent to the radio-frequency equilibration part 8, subjecting to isolation by the said isolated annular assembly 3; meanwhile, radio-frequency equilibration part 8 will receive inherent equilibration signal from the auxiliary equilibration part 7 to offset unconverted part of carrier wave for simultaneous amplification of residual carrier wave and variable power; the amplified signal will pass through carrier wave equilibration part; the carrier wave equilibration part 9 will convert signal received into DC voltage variation signal that is to be sent to the testing closed-loop system 6 subjecting to further equilibration treatment by the DC equilibration part; the testing closed-loop system 6 aims to realize testing of variation component and output of calculations.

The said isolated annular assembly 3 comprises a circulator 12 and two isolators 11 respectively connected to the circulator 12; output terminal of the balance 2 is connected to the circulator 12; one isolator is connected to the power source; whereas the other one is connected to the radio-frequency equilibration part.

The said power source is combined via the power combiner.

The said testing closed-loop system aims to realize testing of variation component; details are stated as follows: Mathematical expression of carrier wave signal is stated as follows:

$$U_{testing} = [A+Bf(t)]*\cos(\omega t + \Delta\varphi)$$

Wherein, A refers to amplitude of fundamental component of reflected wave; f(t) refers to impact of impedance variation on reflection power after quenching; B refers to amplitude of variable power component of reflected wave; $\Delta\phi$ refers to variation component of reflected wave phase after quenching; according to mixing theory, the expression following synchronized frequency mixing is stated as follows: $1/2 [A+Bf(t)]*\cos(\Delta(\varphi)) + 1/2 [A+Bf(t)]*\cos(2\omega t + \Delta(\varphi))$; filter circuit is used to filter $2\omega t$ high-frequency component; residual components following synchronized frequency mixing by the system mainly comprise DC component and variation component converted by the power level as well as phase variation component; viewing from simulation analysis, it can be seen that phase variation component is basically below 0.1; therefore, $\cos(\Delta\varphi)$ is approximately equal to 1; system variation component is divided into DC component and slow variation component; in other words, final closed-loop voltage value $U_{testing}$ is = A+Bf(t).

There will be no variation power component BF(t) =0 if there is no quenching; in view of variation to $U_{testing}$ as incurred by variation to load impedance in case of quenching, real-time monitoring closed-loop can obtain DC voltage output signals at superconducting state for comparison with DC voltage value of fundamental component; meanwhile, to overcome impact from noise produced by system testing, quenching is to be confirmed when the voltage difference is out of certain range.

The present invention aims to make use of radio-frequency wave technology to detect variation to internal resistance of inductance coil at superconducting status to realize quench detection. It is expected to amplify and detect potential power variation (variation to reflection coefficient as incurred by variation to DUT internal resistance) through receiving of reflection power of isolated annular assembly and precise measurement of slight power variation incurred by variation to reflection coefficient to realize quench detection.

Place the inductance coil (DUT) in the Dewar; the coil will change the load impedance from 0+joo at the outlet of Dewar to 0+j0 approximately through balance conversion. Characteristic impedance of transmission line will be available for regulation through design of different balance impedance converters.

The power source as realized through multi-route synthesis as shown in FIG 2 mainly aims to ensure stability of output power; according to synthesis principles, contribution of phase variation to single-route amplifier to gross phase variation to synthesized power may decrease accompanied by increase in synthesis routes; furthermore, randomness of phase variation may subject to mutual offset after increase in routes of amplifier; however, uniform variation under the influence of external factors is excluded.

Meanwhile, according to noise theory, white noise is unavailable for synthesis; therefore, synthesis is favorable for improvement white noise to the power source.

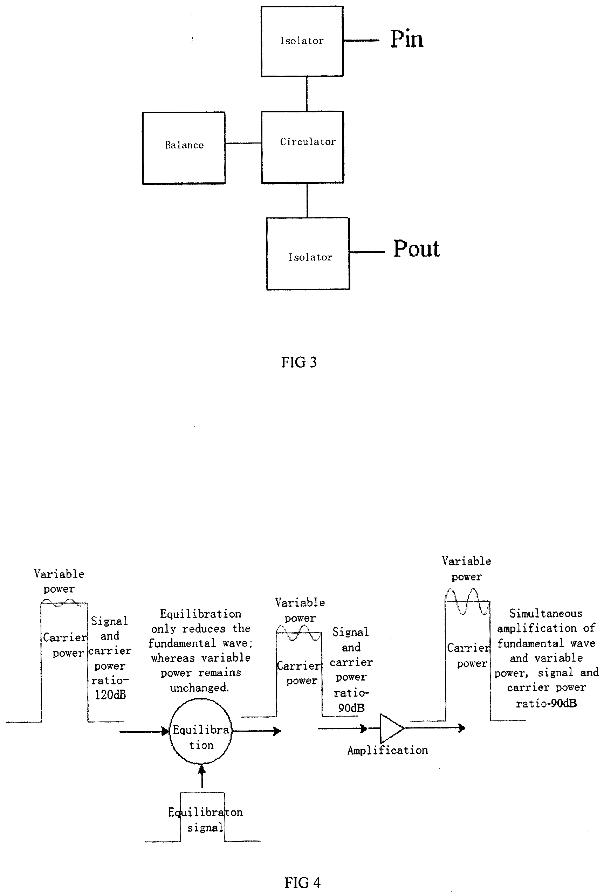

As shown in FIG 3, the isolated annular assembly mainly aims to isolate impact of impedance variation incurred reflection power of port 2 on power source so as to ensure the benchmark of the system, and prevent any new error.

As shown in FIG 4, auxiliary equilibration mainly aims to realize such functions as sampling and judgment of main signals, generation, amplification and phase control of equilibration signals as well as closed loop of inherent stability. According to its major principles, equilibration aims to make use of inherent equilibration signals to offset unchanged part of carrier wave, and simultaneously amplify residual carrier wave and variable power with the help of amplifier so as to reduce system' s dynamic demands, and obtain sampling signals of higher precision. Firstly, the system makes use of inherent equilibration signals to offset unchanged part of carrier wave, and simultaneously amplify residual carrier wave and variable power with the help of amplifier so as to reduce system' s dynamic demands. For radio-frequency equilibration, single equilibration can realize an improvement by 15dB approximately; this is mainly restricted by direct sampling precision of current radio-frequency AD and precision of phase shifter and attenuator. It is essential to carry out equilibration repeatedly to improve radio-frequency equilibration.

Realization of carrier wave equilibration: Convert variation to reflection coefficient and phase into variation to DC voltage in the form of carrier wave equilibration to reduce detection difficulty.

Realization of DC equilibration: To further relax requirements for follow-up detection circuits, the system is designed with primary DC equilibration that mainly makes use of high-sensitivity amplification to further minimize the difference to amplitude ratio between DC level A converted from fundamental wave and Bf (t).

Realization of detection closed loop: Detection closed-loop circuit mainly comprises ADC, FPGA, DAC and so on, which is expected to realize detection of variation component and output of calculations through closed-loop control of the whole system.

**Claims**

1. A method using radio-frequency technology for superconducting magnet quench detection, **characterized in that** it comprises an inductor to be tested, a balance, an isolated annular assembly, a power source, an equilibration treatment part and a testing closed-loop system; the said inductor to be tested is place in the Dewar; the said equilibration treatment part comprises an auxiliary equilibration part, a radio-frequency equilibration part, a carrier wave equilibration part and a DC equilibration part; the said power source is connected to the isolated annular assembly, auxiliary equilibration part and carrier wave equilibration part respectively; impedance to the said inductor to be tested is to be converted by the Balance to change the load impedance at the outlet of Dewar from 0+joo to 0+j0; j is an imaginary number; the converted load impedance is to be sent to the radio-frequency equilibration part, subjecting to isolation by the said isolated annular assembly; meanwhile, radio-frequency equilibration part will receive inherent equilibration signal from the auxiliary equilibration part to offset unconverted part of carrier wave for simultaneous amplification of residual carrier wave and variable power; the amplified signal will pass through carrier wave equilibration part; the carrier wave equilibration part will convert signal received into DC voltage variation signal that is to be sent to the testing closed-loop system subjecting to further equilibration treatment by the DC equilibration part; the testing closed-loop system aims to realize testing of variation component and output of calculations.

2. A method using radio-frequency technology for superconducting magnet quench detection according to Claim 1, **characterized in that** the said isolated annular assembly comprises a circulator and two isolators respectively connected to the circulator; output terminal of the balance is connected to the circulator; one isolator is connected to the power source; whereas the other one is connected to the radio-frequency equilibration part.

3. A method using radio-frequency technology for superconducting magnet quench detection according to Claim 1, **characterized in that** the said power source is combined via the power combiner.

**4.** A method using radio-frequency technology for superconducting magnet quench detection according to Claim 1, **characterized in that** the said testing closed-loop system aims to realize testing of variation component; details are stated as follows:

Mathematical expression of carrier wave signal is stated as follows:

$$U_{testing} = [A+Bf(t)]^{*}\cos(\omega t+\Delta\varphi)$$

Wherein, A refers to amplitude of fundamental component of reflected wave; f(t) refers to impact of impedance variation on reflection power after quenching; B refers to amplitude of variable power component of reflected wave; $\Delta\phi$ refers to variation component of reflected wave phase after quenching; according to mixing theory, the expression following synchronized frequency mixing is stated as follows:

$$1/2\ [A+Bf(t)]^{*}\cos(\Delta\varphi) +1/2\ [A+Bf(t)]^{*}\cos(2\omega t+\Delta\varphi)$$

Filter circuit is used to filter $2\omega t$ high-frequency component; residual components following synchronized frequency mixing by the system mainly comprise DC component and variation component converted by the power level as well as phase variation component; viewing from simulation analysis, it can be seen that phase variation component is basically below 0.1; therefore, $\cos(\Delta(\varphi)$ is approximately equal to 1; system variation component is divided into DC component and slow variation component; in other words, final closed-loop voltage value $U_{testing}$ is = A+Bf(t). There will be no variation power component BF(t) =0 if there is no quenching; in view of variation to $U_{testing}$ as incurred by variation to load impedance in case of quenching, real-time monitoring closed-loop can obtain DC voltage output signals at superconducting state for comparison with DC voltage value of fundamental component; meanwhile, to overcome impact from noise produced by system testing, quenching is to be confirmed when the voltage difference is out of certain range.

```
┌──────────┐
│  Power   │
│  source  │
└──────────┘
```

```
┌──────┐   ┌─────────┐   ┌──────────┐   ┌──────────┐
│      │   │         │   │ Isolated │   │Auxiliary │
│ DUT  │   │ Balance │   │ annular  │   │equilibra-│
│      │   │         │   │ assembly │   │  tion    │
└──────┘   └─────────┘   └──────────┘   └──────────┘

           ┌──────────┐   ┌──────────┐   ┌──────────┐   ┌──────────┐
           │ Radio-   │   │Carrier wave│ │   DC     │   │Detection │
           │frequency │   │equilibra-│   │equilibra-│   │closed loop│
           │equilibra-│   │  tion    │   │  tion    │   │          │
           │  tion    │   └──────────┘   └──────────┘   └──────────┘
           └──────────┘
```

FIG 1

FIG 2

Pin

Isolator

Balance    Circulator

Isolator

Pout

FIG 3

Variable
power

Carrier | Signal
power  | and
       | carrier
       | power
       | ratio-
       | 120dB

Equilibration
only reduces the
fundamental wave;
whereas variable
power remains
unchanged.

Variable
power

Carrier | Signal
power  | and
       | carrier
       | power
       | ratio-
       | 90dB

Variable
power

Carrier | Simultaneous
power  | amplification of
       | fundamental wave
       | and variable
       | power, signal and
       | carrier power
       | ratio-90dB

Equilibra
tion

Amplification

Equilibraton
signal

FIG 4

## INTERNATIONAL SEARCH REPORT

| International application No. |
|---|
| PCT/CN2017/078483 |

**A.   CLASSIFICATION OF SUBJECT MATTER**

G01R 27/00 (2006.01) i

According to International Patent Classification (IPC) or to both national classification and IPC

**B.    FIELDS SEARCHED**

Minimum documentation searched (classification system followed by classification symbols)

G01R 27/-; G01R 31/-

Documentation searched other than minimum documentation to the extent that such documents are included in the fields searched

Electronic data base consulted during the international search (name of data base and, where practicable, search terms used)

CPC, CNABS, CNTXT, CNKI, GOOGLE, VEN: 失超, 超导, 电压, 射频, 对消, 巴伦, superconduct+, voltage, radio Frequency, RF, cancel+, balun

**C.   DOCUMENTS CONSIDERED TO BE RELEVANT**

| Category* | Citation of document, with indication, where appropriate, of the relevant passages | Relevant to claim No. |
|---|---|---|
| A | CN 102346239 A (INSTITUTE OF PLASMA PHYSICS , CHINESE ACADEMY OF SCIENCES) 08 February 2012 (08.02.2012), entire document | 1-4 |
| A | CN 101446610 A (CHINA ELECTRIC POWER RESEARCH INSTITUTE) 03 June 2009 (03.06.2009), entire document | 1-4 |
| A | CN 101126787 A (INSTITUTE OF ELECTRICAL ENGINEERING, CHINESE ACADEMY OF SCIENCES) 20 February 2008 (20.02.2008), entire document | 1-4 |
| A | CN 104614605 A (INSTITUTE OF PLASMA PHYSICS , CHINESE ACADEMY OF SCIENCES) 13 May 2015 (13.05.2015), entire document | 1-4 |
| A | JP 2014149264 A (FUJI ELECTRIC CO., LTD.) 21 August 2014 (21.08.2014), entire document | 1-4 |

☒ Further documents are listed in the continuation of Box C.          ☒ See patent family annex.

| | |
|---|---|
| *        Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"    document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"document member of the same patent family |

| Date of the actual completion of the international search | Date of mailing of the international search report |
|---|---|
| 14 August 2017 | 29 August 2017 |

| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br><br>ZHI, Xinxin<br><br>Telephone No. (86-10) 62085684 |

Form PCT/ISA /210 (second sheet) (July 2009)

## INTERNATIONAL SEARCH REPORT

| International application No. |
| --- |
| PCT/CN2017/078483 |

C (Continuation).  DOCUMENTS CONSIDERED TO BE RELEVANT

| Category* | Citation of document, with indication, where appropriate, of the relevant passages | Relevant to claim No. |
| --- | --- | --- |
| A | KR 101180250 B1 (KOREA ELECTRIC POWER CORP.) 05 September 2012 (05.09.2012), entire document | 1-4 |
| A | US 2014253111 A1 (OROZCO ANTONIO et al.) 11 September 2014 (11.09.2014), entire document | 1-4 |
| A | US 4371943 A (GENERAL DYNAMICS CORPORATION/ CONVAIR DIV.) 01 February 1983 (01.02.1983), entire document | 1-4 |

Form PCT/ISA /210 (continuation of second sheet) (July 2009)

## INTERNATIONAL SEARCH REPORT
### Information on patent family members

International application No.

PCT/CN2017/078483

| Patent Documents referred in the Report | Publication Date | Patent Family | Publication Date |
|---|---|---|---|
| CN 102346239 A | 08 February 2012 | CN 102346239 B | 10 September 2014 |
| CN 101446610 A | 03 June 2009 | CN 101446610 B | 17 August 2011 |
| CN 101126787 A | 20 February 2008 | CN 101126787 B | 09 June 2010 |
| CN 104614605 A | 13 May 2015 | None | |
| JP 2014149264 A | 21 August 2014 | JP 6123316 B2 | 10 May 2017 |
| KR 101180250 B1 | 05 September 2012 | KR 20120056693 A | 04 June 2012 |
| US 2014253111 A1 | 11 September 2014 | WO 2013074068 A1 | 23 May 2013 |
| | | EP 2780731 A4 | 18 November 2015 |
| | | JP 6039681 B2 | 07 December 2016 |
| | | EP 2780731 A1 | 24 September 2014 |
| | | JP 2014533362 A | 11 December 2014 |
| | | US 9529035 B2 | 27 December 2016 |
| US 4371943 A | 01 February 1983 | None | |

Form PCT/ISA /210 (patent family annex) (July 2009)